# EUROPEAN PATENT APPLICATION

(11) **EP 3 961 706 A1**
(43) Date of publication of application: **02.03.2022**
(21) Application number: 21186715.5
(22) Date of filing: 29.05.2013
(51) Int. Cl.: H01L 25/075, H01L 33/48, F21K 99/00, H01L 27/15, H01L 33/08, H01L 33/00, H01L 33/50, H01L 33/58, H01L 33/60, H01L 33/62, H01L 33/64, F21Y 107/00, F21Y 107/50, F21Y 109/00, F21Y 115/10, H01L 23/00

(54) **ILLUMINATION DEVICE**

(30) Priority: 29.05.2012 TW 101119098; 19.06.2012 TW 101121921; 16.07.2012 TW 101125599; 28.08.2012 TW 101131198; 30.08.2012 TW 101131643; 04.09.2012 TW 101132185; 04.09.2012 TW 101132187; 08.05.2013 TW 102116429; 10.05.2013 TW 102116650
(62) Divisional of application: 13169803.7
(71) Applicant: Epistar Corporation, Hsinchu 300 (TW)
(72) Inventor: Pan, Shyi-Ming, Tao-Yuan Hsien (TW); Cheng, Wei-Kang, Tao-Yuan Hsien (TW); Huang, Chih-Shu, Tao-Yuan Hsien (TW); Lee, Chen-Hong, Tao-Yuan Hsien (TW); Yeh, Shih-Yu, Tao-Yuan Hsien (TW); Pu, Chi-Chih, Tao-Yuan Hsien (TW); Yang, Cheng-Kuang, Tao-Yuan Hsien (TW); Tang, Shih-Chieh, Tao-Yuan Hsien (TW); Hong, Siang-Fu, Tao-Yuan Hsien (TW); Wang, Tzu-Hsiang, Tao-Yuan Hsien (TW)
(74) Representative: Ter Meer Steinmeister & Partner

(57) **Abstract**

A sapphire substrate configured to form a light emitting diode (LED) chip providing light in multi-directions, a LED chip and an illumination device are provided in the present invention. The sapphire substrate includes a growth surface and a second main surface opposite to each other. A thickness of the sapphire substrate is thicker than or equal to 200 micrometers. The LED chip includes the sapphire substrate and at least one LED structure. The LED structure is disposed on the growth surface and forms a first main surface where light emitted from with a part of the growth surface without the LED structures. At least a part of light beams emitted from the LED structure pass through the sapphire substrate and emerge from the second main surface. The illumination device includes at least one LED chip and a supporting base. The LED chip is disposed on the supporting base.

## Description

### Background of the Invention

### 1. Field of the Invention

The present invention relates to a sapphire substrate, a light emitting diode chip, and an illumination device, and more particularly, to a sapphire substrate configured to form a light emitting diode chip providing light in multi-directions, a light emitting diode chip, and an illumination device including the light emitting diode chip.

### 2. Description of the Prior Art

A light beam emitted from a light emitting diode (LED) is a kind of directional light source, which is different from a dispersive light source of a conventional bulb. Accordingly, applications of LED are limited. For instance, the conventional LED cannot or may be hard to provide required lighting effect for indoor and outdoor illumination applications. Additionally, conventional LED illumination devices emit light beams from a single side and luminous efficiency of the conventional LED illumination device is relatively low accordingly.

### Summary of the Invention

It is one of the objectives of the present invention to provide a sapphire substrate configured to form a light emitting diode (LED) chip providing light in multi-directions, a light emitting diode chip, and an illumination device including the light emitting diode chip. The purposes of luminous efficiency enhancement, light shape improvement, and cost reduction may then be achieved.

A preferred embodiment of the present invention provides a sapphire substrate configured to form a light emitting diode chip providing light in multi-directions. The sapphire substrate includes a growth surface and a second main surface opposite to each other. A thickness of the sapphire substrate is thicker than or equal to 200 micrometers.

A preferred embodiment of the present invention provides a light emitting diode (LED) chip. The LED chip includes a transparent substrate, a plurality of LED structures, an insulating layer and a conductive pattern. The transparent substrate has a growth surface and a second main surface disposed opposite to each other. The LED structures are disposed on the growth surface and form a first main surface where light emitted from with at least a part of the growth surface without the LED structures. Each of the LED structures includes a first electrode and a second electrode. The insulating layer is disposed on at least some of the LED structures. The conductive pattern is disposed on the insulating layer and electrically connected to at least some of the first electrodes and at least some of the second electrodes. Light emitted from at least one of the LED structures passes through the transparent substrate and emerges from the second main surface.

Another preferred embodiment of the present invention provides a LED chip. The LED chip includes a transparent substrate and at least one LED structure. A material of the transparent substrate includes sapphire, and the transparent substrate has a growth surface and a second main surface disposed opposite to each other. The LED structure is disposed on the growth surface The LED structure has a beam angle greater than 180 degrees, and at least a part of light beams emitted from the LED structure pass through the transparent substrate and emerge from the second main surface.

Another preferred embodiment of the present invention provides a LED chip. The LED chip includes a transparent substrate, at least one LED structure and a wavelength conversion layer. The transparent substrate has a growth surface and a second main surface disposed opposite to each other. The LED structure is disposed on the growth surface and forms a first main surface where light emitted from with at least a part of the growth surface without the LED structure. The LED structure has a beam angle greater than 180 degrees, and at least a part of light beams emitted from the LED structure pass through the transparent substrate and emerge from the second main surface. The wavelength conversion layer is at least disposed on the LED structure or the second main surface. The wavelength conversion layer at least partially absorbs a light beam emitted from the LED structure and coverts the light beam into another light beams having different wavelength range.

Another preferred embodiment of the present invention provides a LED chip. The LED chip includes a transparent substrate and a plurality of LED structures. The transparent substrate has a growth surface and a second main surface disposed opposite to each other. The LED structures are disposed on the growth surface. A light emitting surface of each LED structure uncovered by the transparent substrate and at least a part of the growth surface without the LED structures form a first main surface where light emitted from. Each of the LED structures has a beam angle greater than 180 degrees. Light emitted from at least one of the LED structures passes through the transparent substrate and emerges from the second main surface. An area of the first main surface or an area of the second main surface is larger than 5 times of a total area formed from at least one of the light emitting surfaces of each LED structure.

Another preferred embodiment of the present invention provides a LED chip. The LED chip includes a transparent substrate, at least one diamond-like carbon (DLC) film, and at least one LED structure. The transparent substrate has a growth surface and a second main surface disposed opposite to each other. The DLC film is disposed on the transparent substrate. The LED structure is disposed on the growth surface. A light emitting surface of the LED structure uncovered by the transparent substrate and at least a part of the growth surface without the LED structure form a first main surface where light emitted from. The LED structure has a beam angle greater than 180 degrees, and at least a part of light beams emitted from the LED structure pass through the transparent substrate and emerge from the second main surface.

Another preferred embodiment of the present invention provides a LED chip. The LED chip includes a transparent substrate, at least one LED structure and a reflector. The transparent substrate has a growth surface and a second main surface disposed opposite to each other. The reflector is disposed on the second main surface. The LED structure is disposed on the growth surface. A light emitting surface of the LED structure uncovered by the transparent substrate and at least part of the growth surface without the LED structure form a first main surface where light emitted from. The LED structure has a beam angle greater than 180 degree.

Another preferred embodiment of the present invention provides a LED chip. The LED chip includes a transparent substrate, at least one LED structure, a first connecting conductor and a second connecting conductor. The transparent substrate has a growth surface and a second main surface disposed opposite to each other. The LED structure is disposed on the growth surface and forms a first main surface where light emitted from with at least a part of the growth surface without the LED structure. The LED structure has a beam angle greater than 180 degrees, and at least a part of light beams emitted from the LED structure pass through the transparent substrate and are emitted from the second main surface. The first connecting conductor and the second connecting conductor are respectively disposed on two sides of the transparent substrate. The first connecting conductor and the second connecting conductor are electrically connected to the LED structure.

Another preferred embodiment of the present invention provides an illumination device. The illumination device includes a supporting base and an LED chip providing light in multi-directions, wherein the LED chip is disposed on the supporting base.

Another preferred embodiment of the present invention provides an illumination device. The illumination device includes a LED chip and a support. The LED chip includes a transparent substrate, at least one LED structure, a first connecting conductor and a second connecting conductor. The transparent substrate has a growth surface and a second main surface disposed opposite to each other. The LED structure is disposed on the growth surface and forms a first main surface where light emitted from with at least a part of the growth surface without the LED structure. The LED structure has a beam angle greater than 180 degrees, and at least a part of light beams emitted from the LED structure pass through the transparent substrate and are emitted from the second main surface. The first connecting conductor and the second connecting conductor are respectively disposed on two sides of the transparent substrate. The first connecting conductor and the second connecting conductor are electrically connected to the LED structure. The support includes at least one opening, and the LED chip is disposed correspondingly to the opening.

Another preferred embodiment of the present invention provides an illumination device. The illumination device includes a plurality of LED chips and a device frame. Each of the LED chips includes a transparent substrate, at least one LED structure, a first connecting conductor and a second connecting conductor. The transparent substrate has a growth surface and a second main surface disposed opposite to each other. The LED structure is disposed on the growth surface and forms a first main surface where light emitted from with at least a part of the growth surface without the LED structure. The LED structure has a beam angle greater than 180 degrees, and at least a part of light beams emitted from the LED structure pass through the transparent substrate and are emitted from the second main surface. The first connecting conductor and the second connecting conductor are respectively disposed on two sides of the transparent substrate. The first connecting conductor and the second connecting conductor are electrically connected to the LED structure. The device frame includes a supporting base and a plurality of supports extending outward from the supporting base. Each of the supports includes at least one opening, and the LED chips are disposed correspondingly to at least some of the openings.

Another preferred embodiment of the present invention provides an illumination device. The illumination device includes a plurality of LED chips and a light bar. Each of the LED chips includes a transparent substrate, at least one LED structure, a first connecting conductor and a second connecting conductor. The transparent substrate has a growth surface and a second main surface disposed opposite to each other. The LED structure is disposed on the growth surface and forms a first main surface where light emitted from with at least a part of the growth surface without the LED structure. The LED structure has a beam angle greater than 180 degrees, and at least a part of light beams emitted from the LED structure pass through the transparent substrate and are emitted from the second main surface. The first connecting conductor and the second connecting conductor are respectively disposed on two sides of the transparent substrate. The first connecting conductor and the second connecting conductor are electrically connected to the LED structure. The light bar includes a plurality of openings. The light bar has an extending direction, and the openings are disposed along the extending direction. The LED chips are disposed correspondingly to at least some of the openings.

Another preferred embodiment of the present invention provides an illumination device. The illumination device includes a plurality of LED chips and a supporting base. Each of the LED chips includes a transparent substrate, at least one LED structure, a first connecting conductor and a second connecting conductor. The transparent substrate has a growth surface and a second main surface disposed opposite to each other. The LED structure is disposed on the growth surface and forms a first main surface where light emitted from with at least a part of the growth surface without the LED structure. The LED structure has a beam angle greater than 180 degrees, and at least a part of light beams emitted from the LED structure pass through the transparent substrate and are emitted from the second main surface. The first connecting conductor and the second connecting conductor are respectively disposed on two sides of the transparent substrate. The first connecting conductor and the second connecting conductor are electrically connected to the LED structure. The supporting base includes a plurality of openings. The openings are disposed as an array. The LED chips are disposed correspondingly to at least some of the openings.

Another preferred embodiment of the present invention provides a device frame of an illumination device. The device frame includes a supporting base and a plurality of supports. Each of the supports extends from the supporting base. Each of the supports includes at least one opening and a plurality of electrodes disposed on two sides of the opening.

In the LED chip of the present invention, the LED structure is disposed on the transparent substrate, and the transparent substrate allows the light beam emitted by the LED structure passing through. Accordingly, the LED chip in the present invention can emit light in at least multi-directions or all directions. The luminous efficiency of the illumination device may be accordingly enhanced, and the light shape of the LED illumination device may also be improved. Additionally, since the insulating layer, the conductive pattern and the LED structures of the LED chip in the present invention can be fabricated through wafer-level processes, the related manufacturing cost may be reduced, and the corresponding LED chip may have an improved reliability.

These and other objectives of the present invention will no doubt become obvious to those of ordinary skill in the art after reading the following detailed description of the preferred embodiment that is illustrated in the various figures and drawings.

### Brief Description of the Drawings

FIG. 1 and FIG. 2 are schematic structure diagrams illustrating a light emitting diode (LED) chip according to a preferred embodiment of the present invention.
FIGs. 3-5 are schematic diagrams illustrating different types of electrically coupling approaches between a light emitting diode structure and conductors of a preferred embodiment of the present invention.
FIG. 6 and FIG. 7 are schematic diagrams illustrating a disposition of a wavelength conversion layer according to a preferred embodiment of the present invention.
FIG. 8 is a cross-sectional diagram illustrating a LED chip according to another preferred embodiment of the present invention.
FIG. 9 is an equivalent circuit diagram of a LED chip of another embodiment.
FIG. 10 is a schematic diagram illustrating a LED chip of another embodiment.
FIG. 11 is a schematic diagram illustrating a supporting base of a embodiment.
FIG. 12 is a schematic diagram illustrating a circuit board of a embodiment.
FIG. 13 is a schematic diagram illustrating a reflector of a embodiment of the present invention.
FIG. 14 is a schematic diagram illustrating a diamond-like carbon film of a embodiment.
FIG. 15 is a schematic diagram illustrating an illumination device of another embodiment.
FIG. 16 is a schematic diagram illustrating an illumination device of another embodiment.
FIGs. 17-19 are schematic diagrams illustrating a transparent substrate inserted or adhered to a supporting base according to a preferred embodiment of the present invention.
FIG. 20 and FIG. 21 are schematic diagrams illustrating a transparent substrate adhered to a supporting base with supports according to a preferred embodiment of the present invention.
FIG. 22 is a schematic diagram illustrating an illumination device of another embodiment.
FIG. 23 is a diagram illustrating a device frame of an illumination device of another embodiment.
FIG. 24 is a schematic diagram illustrating an illumination device of another embodiment.
FIGs. 25-28 are schematic diagrams illustrating transparent substrates point-symmetrically or line-symmetrically disposed on a supporting structure of a embodiment of the present invention.
FIG. 29 is a schematic diagram illustrating an illumination device of another embodiment.
FIG. 310 and FIG. 31 are schematic diagrams illustrating a lamp housing of a embodiment.

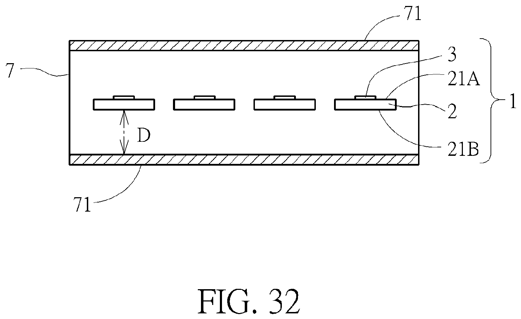

FIG. 32 is a top-view diagram illustrating an advertisement lamp housing of a embodiment.

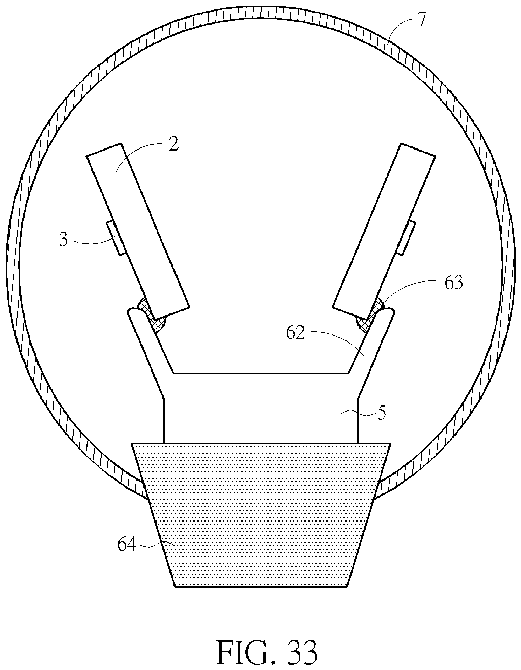

FIGs. 33-36 are schematic diagrams illustrating a bulb lamp of a embodiment.

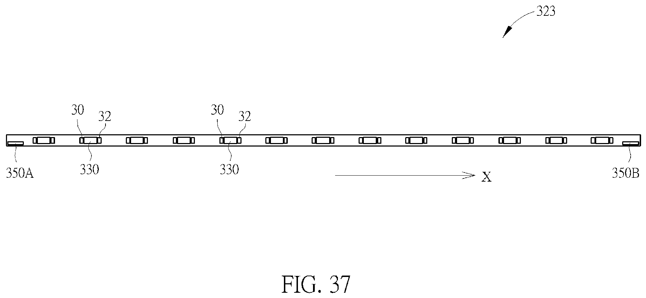

FIG. 37 is a schematic diagram illustrating a light bar of another embodiment.

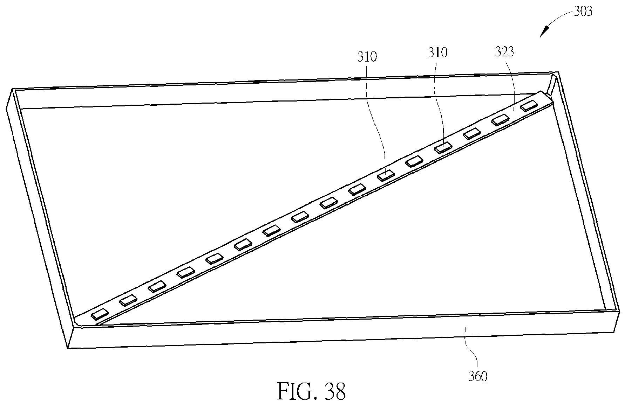

FIG. 38 is a schematic diagram illustrating an illumination device of another embodiment.

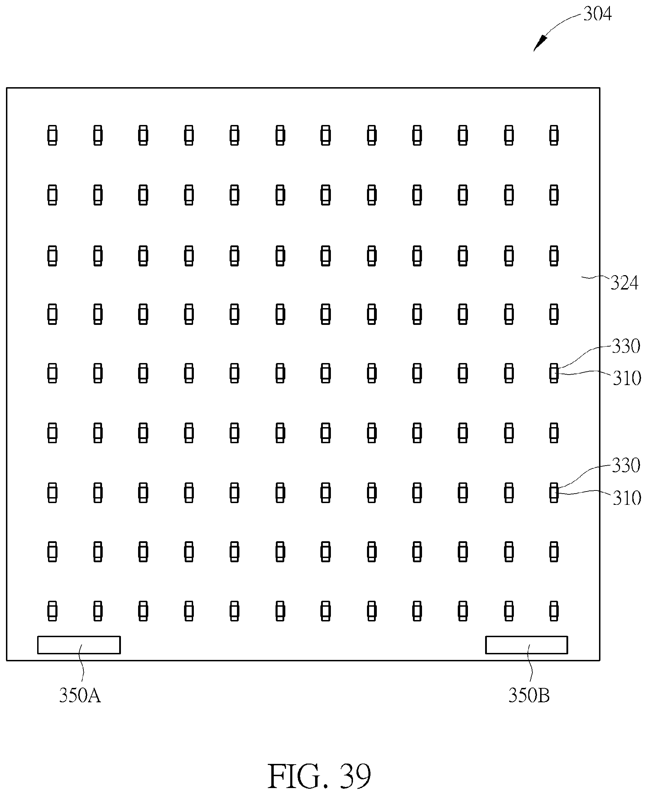

FIG. 39 is a schematic diagram illustrating an illumination device of another embodiment.

### Detailed Description

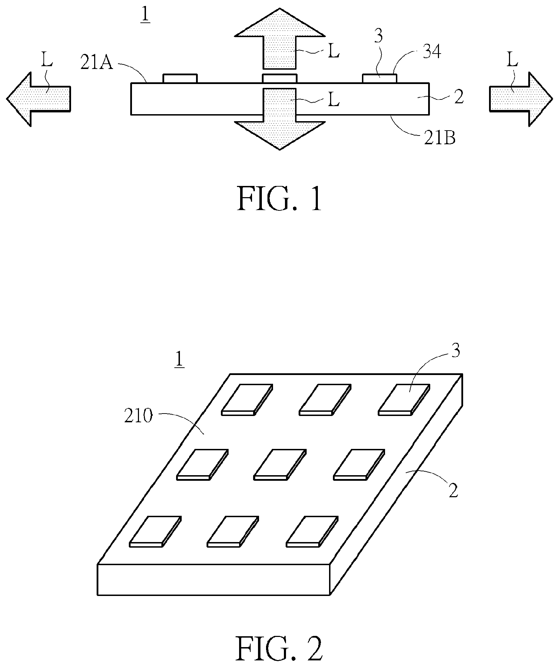

FIG. 1 and FIG. 2 are schematic structure diagrams illustrating a light emitting diode (LED) chip or a light emitting plate according to a preferred embodiment of the present invention. As shown in FIG. 1 and FIG. 2, a LED chip 1 includes a transparent substrate 2, a growth surface 210, a first main surface 21A, a second main surface 21B and at least one LED structure 3 providing light in multi-directions. The transparent substrate 2, which is a sheet type substrate, has two main surfaces, and one of the surfaces is the growth surface 210. The LED structure 3 capable of emitting light is disposed on the growth surface 210. A light emitting surface 34 of the LED structure 3 uncovered by the transparent substrate 2 and at least a part of the growth surface 210 without the LED structure form the first main surface 21A where light emitted from. The second main surface 21B is another main surface of the transparent substrate 2 without the LED structures 3. The disposition described above may also be reversed, or the LED structure 3 may be disposed on the two surfaces of the transparent substrate 2. In one embodiment, LED structures 3 may be disposed on the growth surface 210 of the transparent substrate 2 interlacedly corresponding to other LED structures 3 disposed on the second main surface 21B, such that light beams emitted from LED structure 3 on one surface of the transparent substrate 2 would not be blocked by other LED structure 3 on another surface of the transparent substrate 2. The luminance of the LED chip 1 may be increased accordingly. A material of the transparent substrate 2 may comprise one selected from aluminum oxide (Al2O3), sapphire containing aluminum oxide, silicon carbide (SiC), glass, plastic or rubber. Preferably, the transparent substrate may be a sapphire substrate in a preferred embodiment of the present invention. The structure of the sapphire substrate is substantially single crystal. The sapphire substrate has properties of higher light transmittance and better heat dissipation capability. The sapphire substrate may be used to increase the lifetime of the LED chip 1. However, the conventional sapphire substrate used for forming conventional LED structure may be fragile when applied in the present invention. According to experiment results of the present invention, the transparent substrate 2 of the present invention is preferably a sapphire substrate having a thickness thicker than or equal to 200 micrometers so as to perform better reliability, supporting performance and transparency. For emitting light in multi-directions, including dual-directions or full directions, from the LED chip 1, the LED structure 3 in this invention preferably has a beam angle greater than 180 degrees. Accordingly, the LED structure 3 disposed on the transparent substrate 2 may emit light beams from the light emitting surface 34 toward a direction away from the transparent substrate 2, and the LED structure 3 may also emit light beams at least partially entering the transparent substrate 2. The light beams entering the transparent substrate 2 may emerge from the second main surface 21B opposite to the first main surface 21A, and the light beams entering the transparent substrate 2 may also be emitted from a part of the growth surface 210 without LED structures 3 or emitted from other surfaces of the transparent substrate 2. The LED chip 1 may then be capable of emitting light in multi-directions including dual-directions or full directions. In this invention, an area of the first main surface 21A or an area of the second main surface 21B is larger than 5 times of a total area formed from at least one of the light emitting surfaces 34 of each LED structure, and this is a preferred proportion according to the consideration of both the luminous efficiency and the heat dissipation performance.

Additionally, in another preferred embodiment of the present invention, a difference in color temperatures of light beams emitted from the first main surface 21A and the second main surface 21B of the LED chip 1 is smaller than or equal to 1500K so as to uniform light emitting effects of the LED chip 1. In addition, under the thickness condition of the transparent substrate 2 mentioned above, a light transmittance of the transparent substrate 3 is larger than or equal to 70% for light beams having a wavelength range larger than or equal to 420 nanometers, or light beams having a wavelength rage smaller than or equal to 470 nanometers.

The present invention is not limited to the embodiment described above. The following description will detail the different embodiments in the present invention. To simplify the description, similar components in each of the following embodiments are marked with identical symbols. For making it easier to understand the differences between the embodiments, the following description will detail the dissimilarities among different embodiments and the identical features will not be redundantly described.

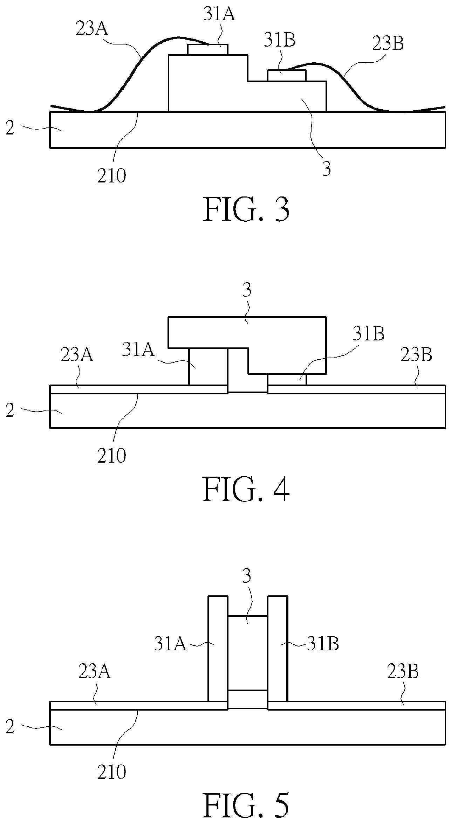

As shown in Figs. 3-5, in the present invention, the LED structure 3 includes a first electrode 31A and a second electrode 31B for receiving electricity. The first electrode 31A and the second electrode 31B are respectively and electrically connected to a first connecting conductor 23A and a second connecting conductor 23B on the transparent substrate 2. FIGs. 3-5 are schematic diagrams illustrating different types of electrically coupling approaches between the light emitting diode structure 3 and the conductors. FIG. 3 illustrates a horizontal type LED structure, the LED structure 3 is formed on the growth surface 210 of the transparent substrate 2, and the electrodes 31A and 31B are coupled to the connecting conductors 23A and 23B by wire bonding. FIG. 4 illustrates a flip structure type LED structure 3, and the LED structure 3 is disposed reversely and coupled to the transparent substrate 2 by the first electrode 31A and the second electrode 31B. The first electrode 31A and the second electrode 31B may be directly coupled to the first connecting conductor 23A and the second connecting conductor 23B by welding or adhering. As shown in FIG. 5, the first electrode 31A and the second electrode 31B are disposed on different surfaces of the LED structure 3, and the LED structure 3 is vertically disposed so as to respectively connect the electrodes 31A and 31B to the connecting conductors 23A and 23B.

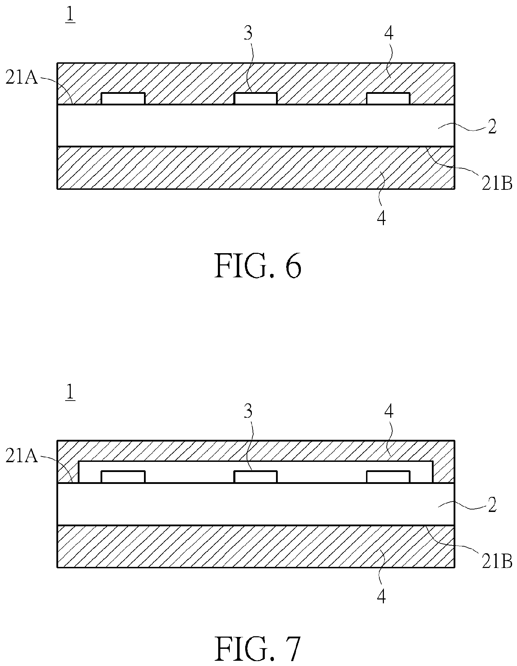

As shown in Fig.6 and FIG. 7, the LED chip 1 in the present invention may further include a wavelength conversion layer 4. The wavelength conversion layer 4 may be selectively disposed on the first main surface 21A or/and the second main surface 21B, or directly on the LED structures 3. The wavelength conversion layer 4 may directly contact the LED structures 3, or the wavelength conversion layer 4 may be separated from the LED structures 3 by a distance without directly contact. The wavelength conversion layer 4 contains at least one kind of fluorescent powders such as organic fluorescent powder or inorganic fluorescent powder of garnet series, sulfate series or silicate series. The wavelength conversion layer 4 may then be able to at least partially absorb a light beam emitted from the LED structure 3 and covert the light beam into another light beams having different wavelength range. For example, when blue light beams are emitted from the LED structure 3, a part of the blue light beams may be converted into yellow light beams by the wavelength conversion layer 4, and the blue light beams and the yellow light beams may be mixed for presenting white light beams emitted from the LED chip 1. Additionally, a luminance of the first main surface 21A is different from a luminance of the second main surface 21B because a light source of the first main surface 21A mainly comes from light beams directly emitted from the LED structure 3, and a light source of the second main surface 21B comes from light beams passing through the transparent substrate 2. Therefore, in a LED chip 1 of another preferred embodiment, concentrations of the fluorescent powders in the wavelength conversion layer 4 disposed on the first main surface 21A and the wavelength conversion layer 4 disposed on the second main surface 21B are arranged correspondingly. Preferably, a ratio of a fluorescent powder concentration in the wavelength conversion layer 4 disposed on the first main surface 21A to a fluorescent powder concentration in the wavelength conversion layer 4 disposed on the second main surface 21B may ranges from 1:0.5 to 1:3, or a ratio of the fluorescent powder concentration in the wavelength conversion layer 4 disposed on the second main surface 21B to the fluorescent powders in the wavelength conversion layer 4 disposed on the first main surface 21A may ranges from 1:0.5 to 1:3. The luminance and the lighting effect of the LED chip 1 may become more appropriate for different applications accordingly. A difference in color temperatures of light beams emitted from the first main surface 21A and the second main surface 21B may then be controlled to be smaller than or equal to 1500K. A wavelength converting efficiency and light emitting performance of the LED chip 1 may then be enhanced.

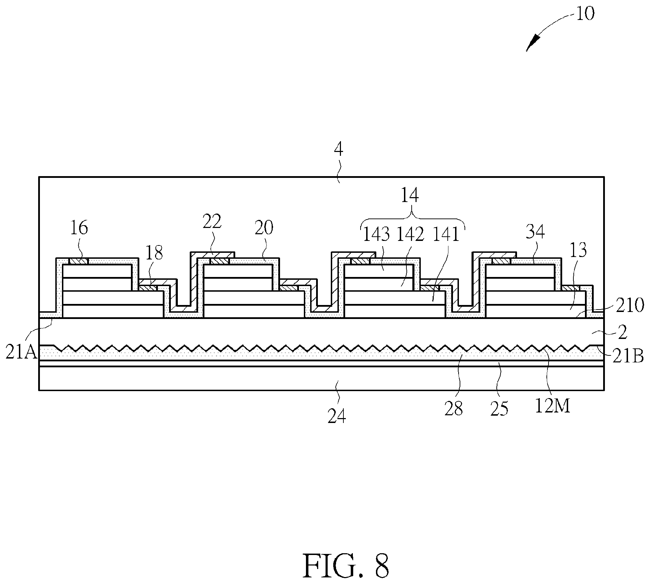

FIG. 8 is a cross-sectional diagram illustrating a LED chip according to another preferred embodiment of the present invention. As shown in FIG. 8, the LED chip 10 in this embodiment includes a transparent substrate 2, a plurality of LED structures 14, an insulating layer 20 and a conductive pattern 22. The transparent substrate 2 has a growth surface 210 and a second main surface 21B disposed opposite to each other. The LED structures 14 are disposed or formed on the growth surface. Each of the LED structures 14 includes a first electrode 16 and a second electrode 18. A light emitting surface 34 of the LED structures 14 uncovered by the transparent substrate 2 and a part of the growth surface 210 without the LED structures 14 form a first main surface 21A where light emitted from. The insulating layer 20 is disposed at least on a part of the LED structure 14. The conductive pattern 22 is disposed on the insulating layer 20 and electrically connected to at least a part of the first electrodes 16 and at least a part of the second electrodes 18. The conductive pattern 22 may be a metal line layout or a pattern formed by wire bonding, but the present invention is not limited to this. Other appropriate materials may also be used to form the conductive pattern 22.

The LED structure 14 may include a first semiconductor layer 141, an active layer 142 and a second semiconductor layer 143. The first semiconductor layer 141, the active layer 142 and the second semiconductor layer 143 are sequentially formed on the transparent substrate 2. Preferably, the first semiconductor layer 141 may be an N-type semiconductor layer, and the second semiconductor layer 143 may be a P-type semiconductor layer, but not limited thereto. Materials of the first semiconductor layer 141, the active layer 142, and the second semiconductor layer 143 are selected from IIIA nitride group such as aluminum nitride (AlN) or gallium nitride (GaN), but not limited thereto. The LED chip 10 may further include a buffer layer 13 formed between the first semiconductor layer 141 and the transparent substrate 2. A material of the buffer layer 13 may also be selected from IIIA nitride group such as aluminum nitride or gallium nitride, but not limited thereto. The first electrode 16 is electrically connected to the second semiconductor layer 143, and the second electrode 18 is electrically connected to the first semiconductor layer 141. The first electrode 16 and the second electrode 18 may be metal electrodes, but not limited thereto.

In addition, the LED chip 10 may further include wavelength conversion layers 4 disposed on the transparent substrate 2 and the LED structures. A light beam (not shown) emitted from the LED structure 14 may have a specific wavelength range. The wavelength conversion layer 4 may convert the light beam having the specific wavelength range into another light beam having different wavelength range or having a wider wavelength rage, and the LED chip 10 may emit the converted light beam accordingly.

In this embodiment, the LED structures 14 are connected in series through the conductive pattern 22, but not limited thereto. In addition, the insulating layer 20, the conductive pattern 22, the LED structures 14 (each of which including the first semiconductor layer 141, the active layer 142 and the second semiconductor layer 143) and the buffer layer 13 can be fabricated in consecutive processes. In other words, after the buffer layer 13, the first semiconductor layer 141, the active layer 142 and the second semiconductor layer 143 are sequentially formed on the transparent substrate 2, the insulating layer 20 and the conductive pattern 22 can be further formed. A dicing process is carried out afterward. Processes for fabricating the insulating layer 20 and the conductive pattern 22 may include photolithography and etching processes, but not limited thereto. Since the insulating layer 20, the conductive pattern 22 and the LED structures 14 in the LED chip 10 of this embodiment are all fabricated through wafer-level processes, the related manufacturing cost may be reduced, and the corresponding LED chip 10 may have an improved reliability.

Additionally, in order to increase intensity and distribution uniformity of the light emitted from the transparent substrate 2, the second main surface 21B may selectively has a non-planar structure 12M. The non-planar structure 12M may include various convex or concave structures, such as pyramid, cone, hemispheroid, triangular prism and so forth. The non-planar structure 12M may be arranged regularly or randomly. Furthermore, a diamond-like carbon (DLC) film 25 may be optionally disposed on the second main surface 21B, which is used to increase the thermal conduction ability and thermal dissipation ability. Furthermore, there may be an optical film 28 between the second main surface 21B and the diamond-like carbon film 25. Preferably, the optical film 28 may be chosen from a material having a refractive index between a refractive index of the transparent substrate 2 and a refractive index of the diamond-like carbon film 25 or the wavelength conversion layer 4, to increase the light output of the LED chip 10.

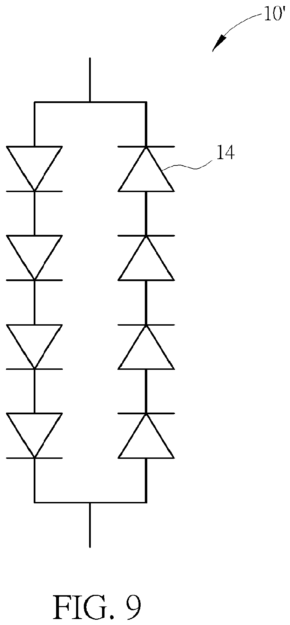

With reference to Fig. 9 accompanied with FIG. 8 and other figures described above, FIG. 9 is an equivalent circuit diagram of a LED chip according to another preferred embodiment of the present invention. As shown in FIG. 9, in this modified embodiment, the LED structures 14 in an LED chip 10' are electrically connected in a hybrid way by the conductive pattern 22; that is, some are in series and the others are in parallel. The LED structures are further electrically coupled to a power supply via the connecting conductors.

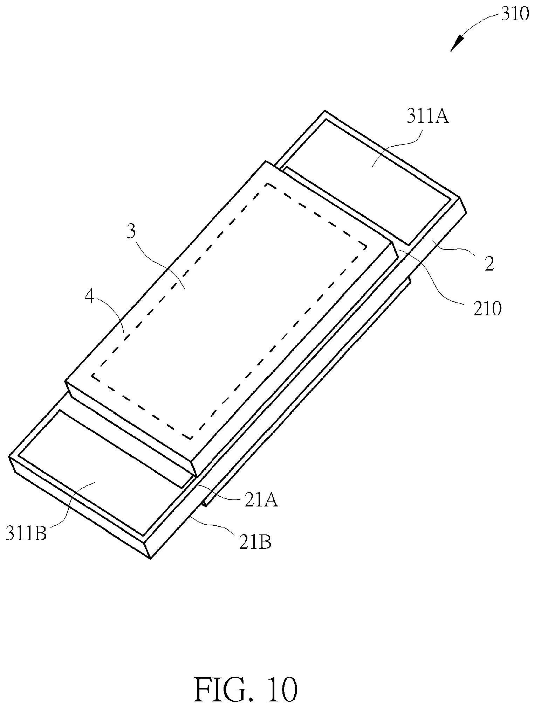

FIG. 10 is a schematic diagram illustrating an illumination device according to another preferred embodiment of the present invention. As shown in FIG. 10, a LED chip 310 in this invention includes the transparent substrate 2, at least one LED structure 3, a first connecting electrode 311A, a second connecting electrode 311B and at least one wavelength conversion layer 4. The LED structure 3 is disposed on the growth surface 210 of the transparent substrate 2 and forms a first main surface 21A where light emitted from. In this embodiment, the LED structure 3 has a beam angle greater than 180 degrees, and at least a part of light beams emitted from the LED structure 3 penetrate into the transparent substrate 2. At least a part of the penetrating light beams may be emitted from a second main surface 21B which is opposite to the first main surface 21A, and the other penetrating light beams may be emitted from other surfaces of the transparent substrate 2, so as to form the LED chip 310 providing light in multi-directions. The first connecting electrode 311A and the second connecting electrode 311B are respectively disposed on different sides of the transparent substrate 2 or on the same side of the transparent substrate 2 (not shown in FIG. 10). The first connecting electrode 311A and the second connecting electrode 311B may be electrodes of the chip 310 respectively formed by extension parts of a first connecting conductor and a second connecting conductor on the transparent substrate 2, and the first connecting electrode 311A and the second connecting electrode 311B are electrically connected to the LED structure 3 accordingly. The wavelength conversion layer 4 at least covers the LED structure 3 and exposes at least a part of the first connecting electrode 311A and the second connecting electrode 311B. In other words, the wavelength conversion layer 4 may also be disposed without covering the first connecting electrode 311A and the second connecting electrode 311B. The wavelength conversion layer 4 at least partially absorbs a light beam emitted from the LED structure 3 or/and the transparent substrate 2, and coverts the light beam into a light beam having another wavelength range. The converted light and the light which are not absorbed by the wavelength conversion layer 4 may be mixed to extend the total wavelength range of the light beams emitted from the LED chip 310 and improve the light emitting performance of the LED chip 310. Because the LED chip 310 in this embodiment includes the first connecting electrode 311A and the second connecting electrode 311B respectively disposed on the transparent substrate 2, traditional LED packaging process may be omitted and the LED chip 310 may be independently manufactured and then combined with an appropriate supporting base. Accordingly, the total manufacturing yield may be improved, the structure may be simplified and the applications of the corresponding supporting base may also be increased.

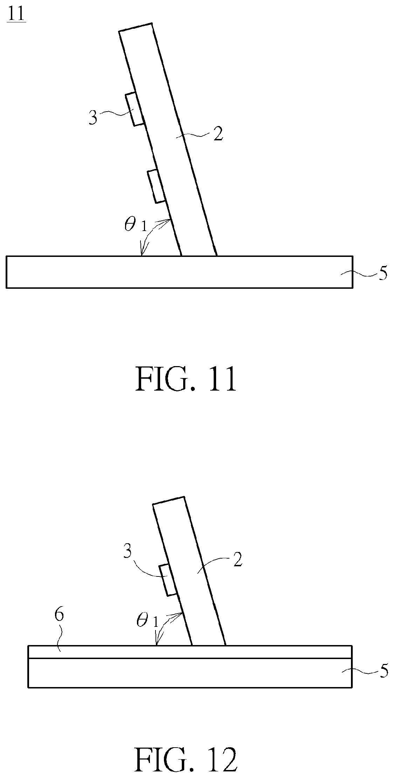

As shown in Fig. 11, an illumination device 11 is provided in this embodiment. The illumination device 11 includes a supporting base 5 and the LED chip described above. The transparent substrate 2 of the LED chip may stand on (or lie on) and be electrically coupled to the supporting base 5. A first angle θ1 exists between the transparent substrate 2 and the supporting base 5. The first angle θ1 may be fixed or be adjusted according to the light shape requirement of the illumination device. Preferably, the first angle θ1 ranges from 30 degrees to 150 degrees.

As shown in Fig.12, the supporting base 5 of the illumination device 11 in the present invention may further includes a circuit board 6 electrically coupled to a power supply. The circuit board 6 is electrically coupled to a first connecting conductor and a second connecting conductor (not shown in FIG. 12) so as to be electrically connected to the LED structure 3. The power supply may then provide electricity to the LED ship 3 for emitting light via the circuit board 6. In other preferred embodiment of the present invention, the LED structure 3 may also be electrically connected to the supporting base directly via the first connecting conductor and the second connecting conductor (not shown in FIG. 12) without the circuit board 6, and the power supply may provide electricity to the LED ship 3 via the supporting base 5.

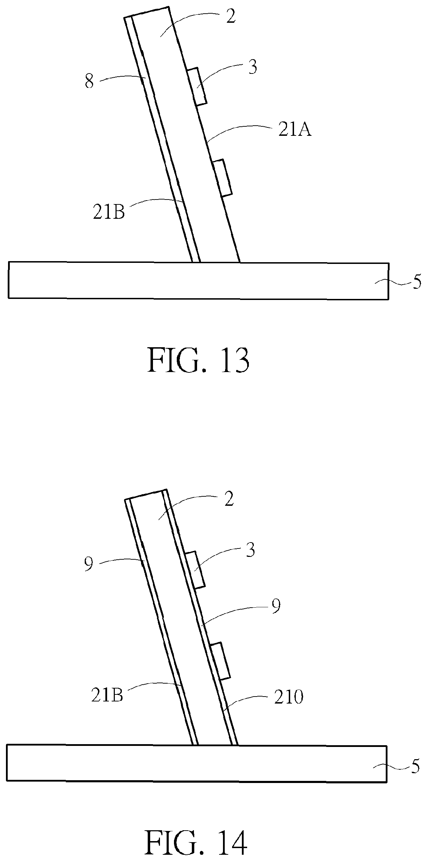

As shown in Fig.13, the illumination device 11 of the present invention may further include a reflector or filter 8 disposed on the second main surface 21B or the growth surface 210. The reflector or filter 8 may be used to reflect at least a part of light beams emitted from the LED structure 3 and passing through the transparent substrate 2. At least a part of the reflected light beams may be changed to be emitted from the first main surface 21A. The reflector 8 may include at least one metal layer or a Bragg reflector, but not limited thereto. The Bragg reflector may be composed of a plurality of insulating thin films with different refractive indexes disposed in a stack configuration, or the Bragg reflector may be composed of a plurality of insulating thin films with different refractive indexes and a plurality of metal oxide layers disposed in a stack configuration.

According to Fig.14, the illumination device 11 of the present invention may further include a diamond-like carbon (DLC) film 9 disposed on the growth surface 210 or/and the second main surface 21B of the transparent substrate 2 so as to enhance the thermal conductive ability and the heat dissipating performance.

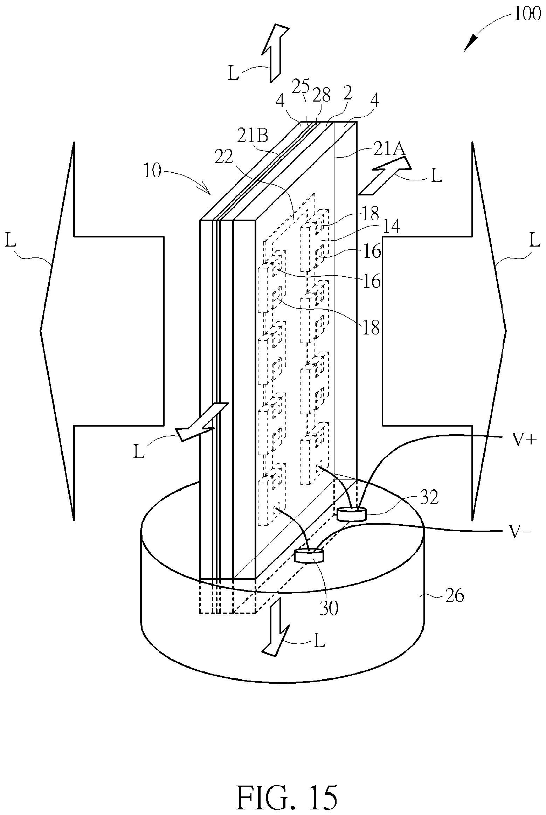

FIG. 15 is a schematic diagram illustrating an illumination device according to another preferred embodiment of the present invention. As shown in FIG. 15, an illumination device 100 in this embodiment includes a LED chip 10 and a supporting base 26. The LED chip 10 may be at least partially embedded into the supporting base 26, and the LED chip 10 is electrically connected to the electrode 30 and the electrode 32 of the supporting base 26 via the connecting conductors. Driving voltage V+ and driving voltage V-may be provided through the electrodes 30 and 32 respectively to the LED chip 10 for emitting a light beam L. In the illumination device 100 of this embodiment, the structure of the LED chip 10 may be similar to the LED chip of other embodiments described above, and the conductive pattern 22 is electrically connected to the first electrodes 16 and the second electrodes 18 of at least a part of the LED structures 14 so as to electrically connect at least some of the LED structures 14 in series or other approaches such as in parallel. The conductive pattern 22 may be a metal line layout or a pattern formed by wire bonding, but not limited thereto. Other appropriate materials or structures may also be used to form the conductive pattern 22. The first electrode 16 and the second electrode 18, which are not connected to the conductive pattern 22, are respectively and electrically connected to the electrode 30 and the electrode 32 of the supporting base 26 via the connecting conductors. Additionally, at least one of the LED structures 14 of the LED chip 10 emits the light beam L with a beam angle greater than 180 degrees or has a plurality of light emitting surfaces, and then the LED chip 10 may emits light beams from the first main surface 21A and the second main surface 21B. Furthermore, because some of the light beams may be emitted directly from the LED structure 14 and/or the other four side surfaces of the transparent substrate 2, the LED chip 10 may accordingly emit light from six sides or in full directions.

Additionally, the LED chip 10 in this embodiment may further includes a wavelength conversion layer 4, a DLC film 25 and an optical film 28 disposed on the second main surface 21B of the transparent substrate 2. The wavelength conversion layer 4 may further be disposed on the LED structures 14 or the first main surface 21A. The wavelength conversion layer 4 may covert at least a part of light beams emitted from the LED structures 14 into another light beams having different wavelength range so as to emit light with specific color or light having a wider wavelength range from the LED chip 10. For example, when blue light beams are emitted from the LED structure 14, a part of the blue light beams may be converted into yellow light beams by the wavelength conversion layer 4, and the blue light beams and the yellow light beams may be mixed for presenting white light beams emitted from the LED chip 10. The DLC film 25 and the optical film 28 may be used to enhance the thermal dissipation ability and the light emitting efficiency of the LED structure 14 and the LED chip 10. The transparent substrate 2 preferably includes materials with high thermal conductivity, and heat generated from the LED structure 14 may be accordingly dissipated directly to the supporting base 26, such that the high-power LED structures can be applied in the illumination device of the present invention accordingly. However, in a preferred embodiment of the present invention, at the same power consumption of the illumination device, more LED structures with relatively low power are dispersed on the transparent substrate 2 so as to fully utilize the thermal conductivity capability of the transparent substrate 2. For example, a power of each LED structure 14 in this embodiment may be equal to or lower than 0.2 watt, but not limited thereto.

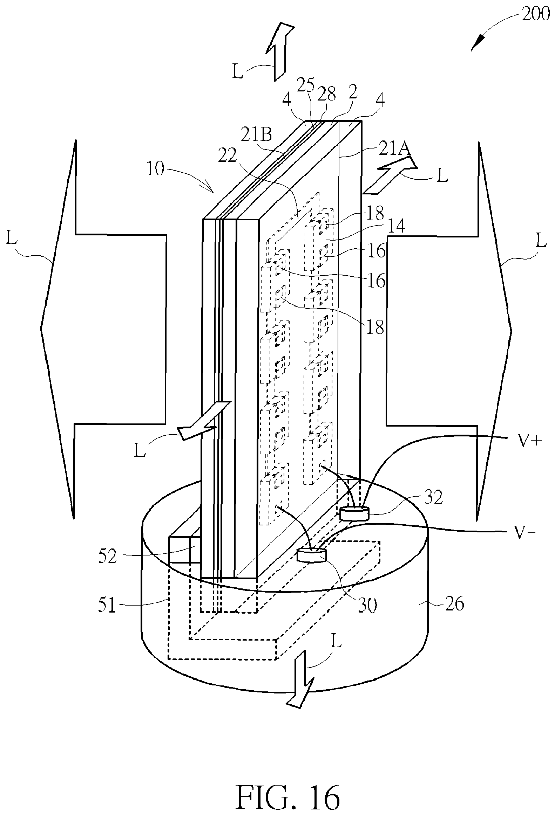

FIG. 16 is a schematic diagram illustrating an illumination device according to a preferred embodiment of the present invention. As shown in FIG. 16, an illumination device 200 in this embodiment may further includes a support 51 configured to connect the LED chip 10 and the supporting base 26. The LED chip 10 is fixed on a side of the support 51 by a bonding layer 52, and another side of the support 51 may be disposed on the supporting base 26. Additionally, the support 51 may be flexible so as to form an adjustable angle between the LED chip 10 and the supporting base 26, and the angle ranges from 30 degrees to 150 degrees. A material of the support 51 may include one selected from aluminum, composite metallic material, copper conductor, electric wire, ceramic substrate, printed circuit board, or other appropriate materials.

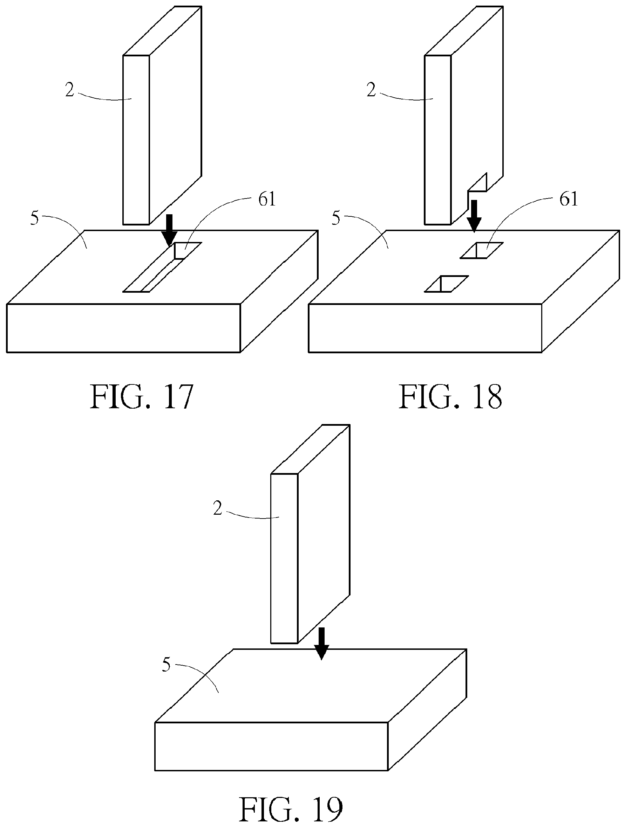

As shown in Figs. 17-19, when the transparent substrate 2 in the present invention is disposed on a supporting base 5, the transparent substrate 2 may be inserted or bonded to the supporting base 5.

As shown in FIG. 17, when the transparent substrate 2 is disposed on the supporting base 5, the transparent substrate 2 is inserted into a single socket 61 of the supporting base 5, and the LED chip may be electrically coupled to the single socket 61 via connecting conductors. The LED structures (not shown in FIG. 17) on the transparent substrate 2 have to be electrically coupled to a power supply from or through the supporting base 5, and at least part of the conductive pattern or the connecting conductors are extended to an edge of the transparent substrate 2 and integrated in to an connecting finger having a plurality of conductive contact sheets or an electrically connecting port such as the connecting electrodes 311A and 311B described above (not shown in FIG. 17). When the transparent substrate 2 is inserted into the socket 61, the LED structure (not shown in FIG. 17) may then receive electricity from or through the supporting base 5, and the transparent substrate 2 may be fixed by the socket 61 of the supporting base 5 accordingly.

FIG. 18 is a schematic diagram illustrating the transparent substrate 2 inserted into multi sockets of the supporting base 5. In this embodiment, the transparent substrate 2 has a dual-pin structure. One of the pins may be configured as a positive electrode of the chip, and another one of the pins may be configured as a negative electrode of the chip. Both of the pins comprise at least a conductive contact sheet respectively so as to act as connecting ports. In other words, at least one electrically connecting port is disposed on the pin. Accordingly, there are at least two sockets 61 having corresponding shape and size with the pins so as to smoothly insert the transparent substrate 2 into the supporting base 5 and provide electricity to the LED structure.

As shown in Fig.19, the transparent substrate 2 is combined with the supporting base 5. In the combining process, metal materials such as gold, tin, indium, bismuth or silver may be used in combining or welding the transparent substrate 2 and the supporting base 5. Additionally, conductive silica gel or epoxy material may also be used in fixing the transparent substrate 2 on the supporting base 5. The conductive pattern and the connecting conductors of the LED chip may be electrically connected to the supporting base via the bonding layer accordingly.

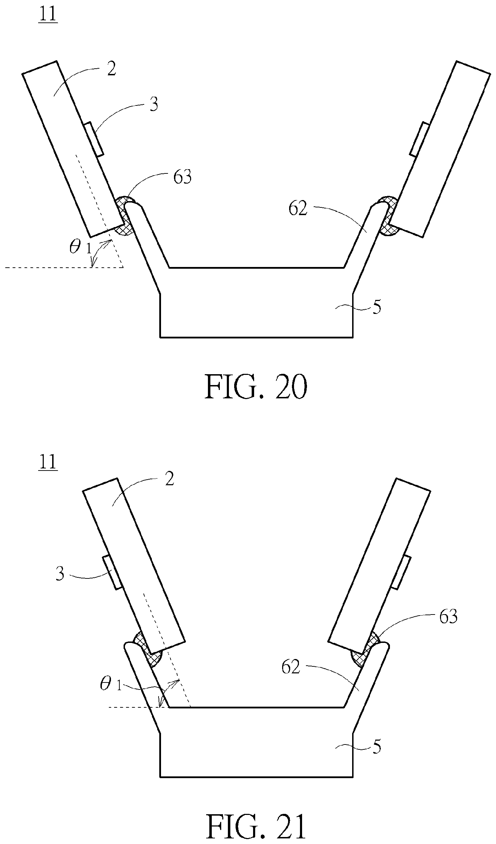

As shown in Fig.20 and FIG. 21, the supporting base 5 of the illumination device 11 described in the present invention may be a substrate comprising one selected from metal such as aluminum, composite metallic material including aluminum, copper conductor, electric wire, ceramic substrate or printed circuit board. There is at least one support 62 on a surface or edge of the supporting base 5. The support 62 may be separated from the supporting base 5, or the support 62 and the supporting base 5 are monolithically integrated. The LED chip may be electrically coupled to the support 62 by bonding, and a bonding layer 63 is used to fix the transparent substrate 2 on the supporting base 5. The first angle θ1 is maintained between the transparent substrate 2 and a surface of the supporting base 5 without supports. The LED chip may also be disposed on the surface of the supporting base 5 without supports so as to enhance the light emitting performance of the illumination device 11. Additionally, the LED chip may also be inserted and connected to the support 62 (not shown in FIG. 20 and FIG. 21), wherein a connector may be used to connect the LED chip and the support (and/or the support and the supporting base) so as to fix the transparent substrate 2 on the supporting base 5. Because the supporting base 5 and the support 62 are flexible, it is more convenient to apply the present invention to different applications. Moreover, the color variety of the illumination device 11 may be enhanced for different demands by combining using LED chips having different light colors.

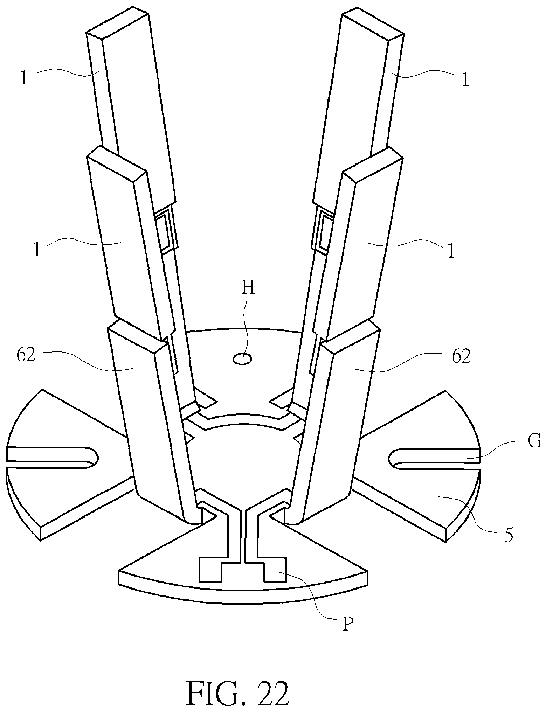

As shown in FIG. 22, an illumination device in this embodiment includes at least one LED chip 1 and a supporting base 5. The supporting base 5 includes at least one support 62 and at least one circuit pattern P. An end of the transparent substrate of the LED chip 1 is electrically coupled to the support 62 so as to avoid or reduce the shielding influence caused by the support 62 for light emitting from the LED chip 1. The supporting base 5 may comprise one selected from metal such as aluminum, composite metallic material including aluminum, copper conductor, electric wire, ceramic substrate or printed circuit board. The support 62 may be formed by cutting and bending a part of the supporting base 5 to form an angle (as the first angle θ1 shown in FIG. 20 and FIG. 21). The circuit pattern P is disposed on supporting base 5, and the circuit pattern P has at least one set of electrical port to be electrically connected to a power supply. Another part of the circuit pattern P extends on the support 62 so as to be electrically connected to the LED chip 1, and the LED chip 1 may than be electrically connected to the power supply via the circuit pattern P of the supporting base 5. In addition, the supporting base 5 may further include at least one hole H or at least one gap G, and fixing devices such as screws, nails or bolts may be used to combine the supporting base 5 with other device via the hole H or the gap G according to the application conditions of the illumination device. Meanwhile, the hole H or the gap G may also be used to increase the heat radiating area and enhance the heat dissipation capability of the illumination device.

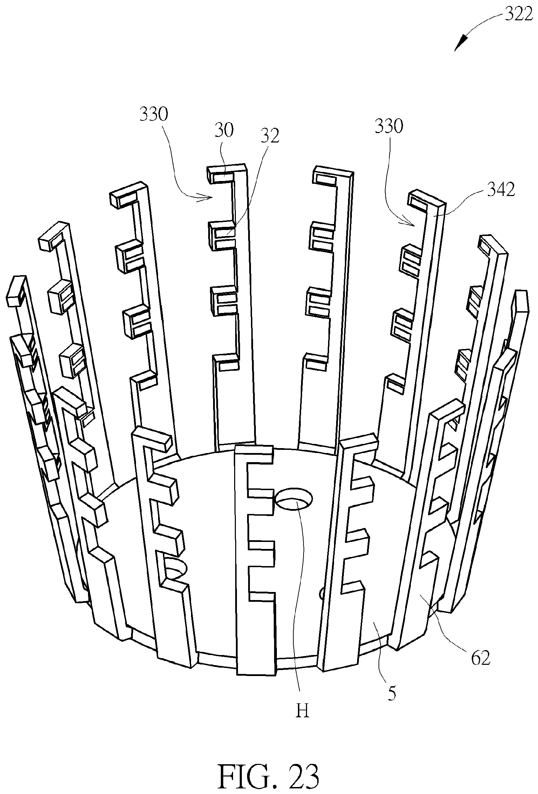

FIG. 23 is a schematic diagram illustrating a device frame of an illumination device according to another preferred embodiment of the present invention. As shown in FIG. 23, a device frame 322 in this embodiment includes a supporting base 5 and at least one support 62. Compared with the embodiment shown in FIG. 22, the support 62 in this embodiment includes at least one stripe part 342 and an opening 330. The electrode 30 and the electrode 32 are respectively disposed on two sides of the opening 330. The stripe part 342 forms at least one wall of the opening 330. One LED chip described in the present invention is disposed correspondingly to the opening 330 and electrically coupled to the support 62. The connecting conductors of the LED chip is electrically connected to the electrode 30 and 32 so as to drive the LED chip by a power supply via the support 62 and the circuit pattern on the supporting base 5. A size of the opening 330 may not be smaller than a main light emitting surface of the LED chip so as to prevent light beams emitted from the LED chip from being blocked by the support 62. An interface between the support 62 and the supporting base 5 may be adjustable so as to adjust the angle between the support 62 and the supporting base 5 as required.

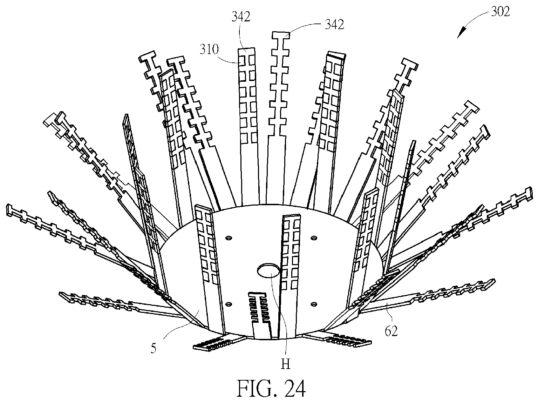

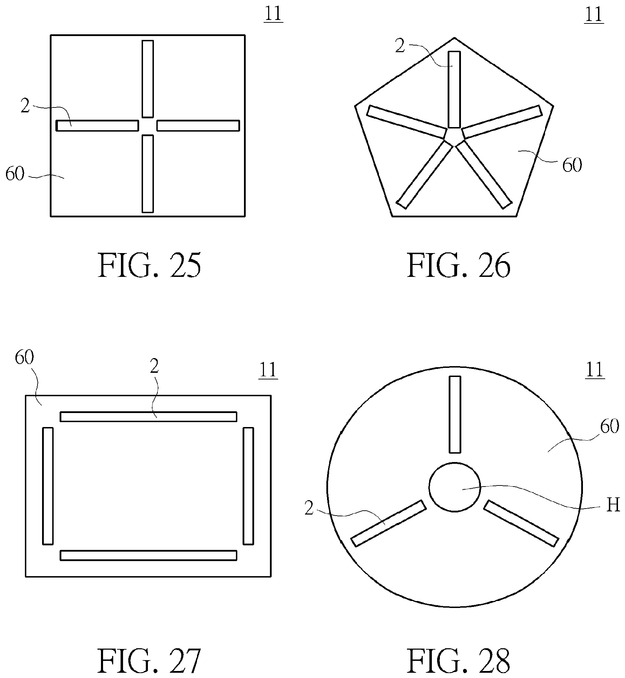

FIG. 24 is a schematic diagram illustrating an illumination device according to another preferred embodiment of the present invention. Compared with the embodiment shown in FIG. 23, an illumination device 302 shown in FIG. 24 further includes at least one support 62 having a plurality of openings 330. The openings 330 are respectively disposed on two opposite sides of the support 62, and the stripe part 342 forms at least one wall of each opening 330. The LED chip 310 are disposed correspondingly to the openings 330, and the conductive pattern or the connecting electrodes (not shown in FIG. 25) of each LED chip 310 are respectively disposed correspondingly and electrically connected to the electrode 30 and 32. The illumination device 302 in this embodiment may further include a plurality of the supports 62. Angles between the supporting base 5 and the supports 62 with the LED chip disposed on may be modified respectively. In other words, an angle between the supporting base 5 and at least one of the supports 62 may be different from an angle between the supporting base 5 and another one of the supports 62 so as to perform required light emitting effects, but not limited thereto. Additionally, LED chips emitting light having different wavelength ranges may be disposed on an identical support or on different supports so as to enrich the color effect of the illumination device.

For enhancing the luminance and improving the light emitting effect, in an illumination device of another preferred embodiment of the present invention, a plurality of the LED chips comprising the transparent substrates are disposed on the supporting bases detailed above or on other supporting structures. A point-symmetric distribution or a line-symmetric distribution may be applied. The LED chips comprising the transparent substrates may be point-symmetrically disposed on the supporting structure or line-symmetrically disposed on the supporting structure. As shown in Figs. 25-28, in the illumination devices of the embodiments shown in FIGs. 25-28, the LED chips are disposed on the supporting structures having different shapes. The light beams emitted from the illumination devices 11 may be uniform because of the point-symmetric distribution or the line-symmetric distribution (the LED structures are not shown in FIGs. 25-28). The light emitting effects of the illumination devices 11 may be further improved by adjusting the first angle described above. As shown in FIG. 25, the LED chips are point-symmetrically arranged and form an angle between each other in 90 degrees. Such that at least two of the LED chips face any one of the four sides of the illumination device 11. As shown in FIG. 26, the angle between the LED chips is smaller than 90 degrees. As shown in FIG. 28, the angle between the LED chips is larger than 90 degrees. In another preferred embodiment of the present invention (not shown), the LED chips may be asymmetrically disposed and at least a part of the LED chips may be disposed in a crowd or separately disposed so as to perform required light shape according to different applications of the illumination device.

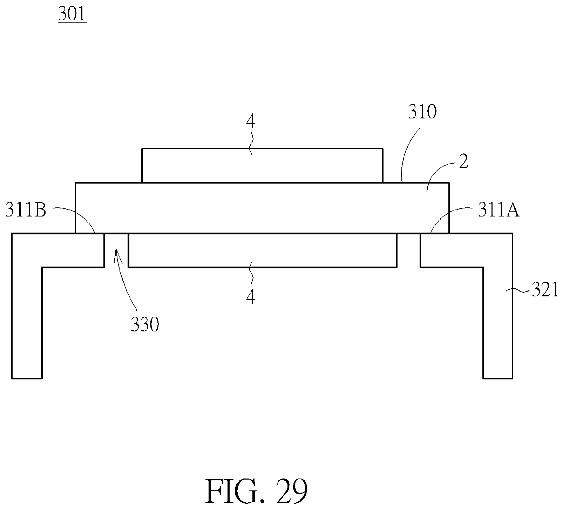

FIG. 29 is a schematic diagram illustrating an illumination device according to another preferred embodiment of the present invention. As shown in FIG. 29, an illumination device 301 includes a LED chip 310 and a support 321. The support 321 includes an opening 330, and the LED chip 310 is disposed correspondingly to the opening 330. In this embodiment, an external part of the support 321 may be work as a pin or be bent to form a connecting pad required in surface mounting so as to be fixed and electrically connected to other electrical circuit units. A light emitting surface of the LED chip 310 is disposed in the opening 330, and the illumination device 301 may still emit light from multi sides or six sides accordingly whether the support 321 is transparent or not.

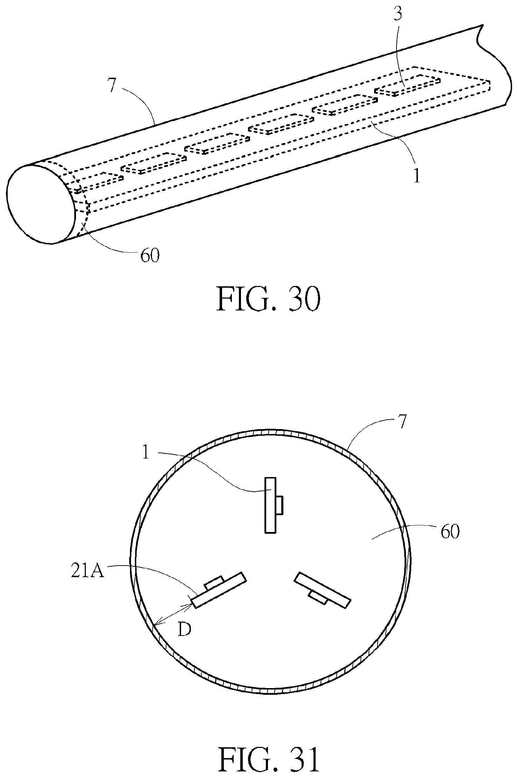

As shown in Fig.30, an illumination device is provided in this embodiment of the present invention. The illumination device includes a lamp housing 7 having a tube shape, at least one LED chip 1 and a supporting structure 60. The LED chip 1 is disposed on the supporting structure 60, and at least a part of the LED chip 1 is disposed in space formed by the lamp housing 7. With reference to Fig.31, when more LED chips 1 are disposed in the lamp housing 7, the first main surfaces 21A of the LED chips 1 are arranged separately and not parallel to one another. Additionally, the LED chips 1 are at least partially disposed in space formed by the lamp housing 7, and the LED chips 1 are not closely adjacent to an inner wall of the lamp housing 7. Preferably, a distance D between the LED chip 1 and the lamp housing 7 may be equal to or larger than 500 micrometers. However, the lamp housing 7 may also be formed by filling glue, and the lamp housing 7 may at least partially cover and directly contact the LED chip 1.

As shown in Fig.32, another illumination device is provided in this embodiment of the present invention. The lamp housing 7 of the illumination device has at least one covering layer 71. The covering layer 71 may be a billboard, signboard or other display devices requiring backlight sources. Light provided from the first main surface 21A and the second main surface 21B of the LED chip 1 in the present invention may be applied as a light source of a backlight for the covering layer 71. A second angle between the LED chip 1 and the covering layer 71 ranges between 0 degree and 45 degrees (the second angle is 0 degree in FIG. 32 and not shown accordingly). In addition, the LED chips 1 are at least partially disposed in space formed by the lamp housing 7 and basically not closely adjacent to the inner wall of the lamp housing 7, and then light beams generated by a light emitting plate/sheet or the LED chip comprising the transparent substrate and the LED structure providing light in multi-directions can uniformly pass through the lamp housing. Preferably, a distance D between the LED chip 1 and the lamp housing 7 may be equal to or larger than 500 micrometers. However, the lamp housing 7 may also be formed by filling glue, and the lamp housing 7 may at least partially cover and directly contact the LED chip 1.

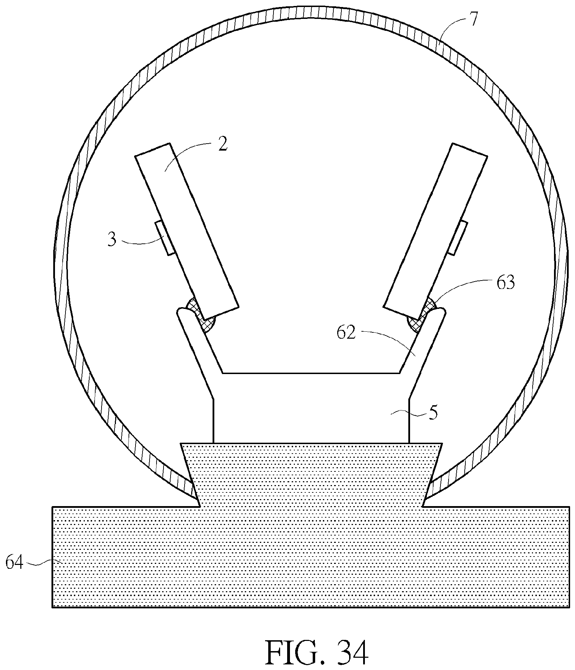

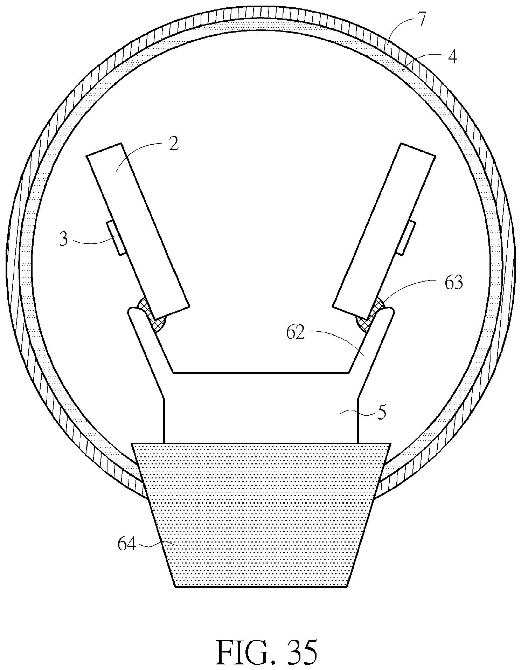

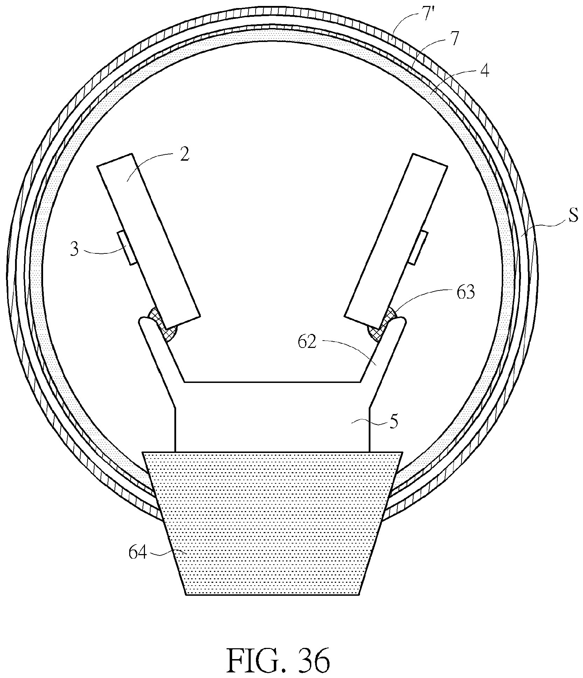

As shown in Figs. 33-36, in other series of embodiments in the present invention, the illumination devices in this series of embodiments may further include a lamp housing 7 having a bulb shape and a base 64. As shown in FIG. 33, compared with the other embodiments described above, the illumination device in this embodiment further includes a lamp housing 7 having a bulb shape, and a supporting base 5 further disposed on a base 64. The base 64 may be a traditional lamp base. The lamp housing 7 may be coupled to the base 64 and cover the LED chip and the supporting base 5, or the lamp housing 7 may be directly coupled to the supporting base 5 and cover the LED chip. The shape of the base 64 may be modified as required. The base 64 may be a platform or include another supporting protrusion (as shown in FIG 34). As shown in FIG. 35, the wavelength conversion layer 4 is coated on an inner wall of the lamp housing 7 so as to convert at least a part of light beams generated from the LED structure 3 into another light beams having different wavelength range before leaving the lamp housing 7. As shown in FIG. 36, a dual housing design including the lamp housing 7 and a lamp housing 7' is disclosed. Space S exists between the lamp housing 7 and the lamp housing 7'. The space S, the lamp housing 7 and the lamp housing 7' may be further modified for performing different patterns and colors of light from the illumination device.

FIG. 37 is a schematic diagram illustrating a light bar according to another preferred embodiment of the present invention. FIG. 38 is a schematic diagram illustrating an illumination device according to another preferred embodiment of the present invention. As shown in FIG. 37, a light bar 323 in this embodiment includes a plurality of openings 330. The light bar 323 has an extending direction X, and the openings 330 are disposed along the extending direction X. A plurality of the LED chips providing light in multi-directions are disposed correspondingly to the openings 330 of the light bar 323, and the light bar 323 can emit light accordingly, but not limited thereto. Additionally, the light bar 323 may further include a plurality of electrodes 30 and 32, a first external connecting electrode 350A and a second external connecting electrode 350B. The electrical polarity of the electrode 30 is different from the electrode 32. The electrodes 30 and the electrodes 32 are respectively disposed on the same side or different sides of each opening 330. The first external connecting electrode 350A and the second external connecting electrode 350B are electrically connected to the electrodes 30 and the electrodes 32 respectively. The first external connecting electrode 350A and the second external connecting electrode 350B are respectively disposed on the same side or different sides of the light bar 323. As shown in FIG. 37 and FIG. 38, an illumination device 303 may include the light bar 323 described above and a device frame 360, wherein the light bar 323 with LED chips 310 may be vertically disposed, horizontally disposed or inclinedly disposed on the device frame 360. The first connecting electrode 350A and 350B of the light bar 323 may be electrically connected to a power supply via the device frame 360, but not limited thereto. Additionally, other appropriate optical films such as diffusion films may also be applied in the illumination device 303 so as to modify the light emitting effect of the LED chips 310 disposed in the device frame 360.

FIG. 39 is a schematic diagram illustrating an illumination device according to another preferred embodiment of the present invention. As shown in FIG. 39, an illumination device 304 includes a plurality of the LED chips 310 and a supporting base 324. The supporting base 324 includes a plurality of openings 330, and the openings 330 are disposed as an array. The LED chips 310 are disposed correspondingly to the openings 330. The connecting approach of the LED chips 310 on the openings 330 may be similar to that described in the embodiments detailed above, and will not be redundantly described. In addition, the supporting base 324 may further include a first external connecting electrode 350A and a second external connecting electrode 350B so as to be electrically connected to other electrical devices. Additionally, the illumination device 304 in this embodiment may be used as a billboard, signboard or a backlight module, and the supporting base 324 is preferably transparent, but not limited thereto.

The invention has been described with reference to embodiments and the Figures. Yet it is explicitly stated that any feature described with reference to a particular embodiment or Fig. only may well and separately from other features described in connection with this embodiment and/or Fig. implemented in any of the other embodiments described or shown in the Figs.

Also, those skilled in the art will readily observe that numerous modifications and alterations of the device and method may be made while retaining the teachings of the invention. Accordingly, the above disclosure should be construed as limited only by the metes and bounds of the appended claims.

It follows a list of examples:
1. A sapphire substrate, configured to form a light emitting diode chip providing light in multi-directions, comprising a growth surface and a second main surface disposed opposite to each other, wherein a thickness of the sapphire substrate is thicker than or equal to 200 micrometers.
2. The sapphire substrate of example 1, wherein an area of the growth surface or an area of the second main surface is larger than 5 times of an total area formed from at least one light emitting surface of at least one light emitting diode (LED) structure disposed on the growth surface or the second main surface.
3. The sapphire substrate of example 1 or 2, further comprising a reflector or filter disposed on the second main surface or the growth surface.
4. The sapphire substrate of any of the preceding examples, wherein a light transmittance of the sapphire substrate is larger than or equal to 70% for light beams having a wavelength ranges from 420 nanometers to 470 nanometers.
5. The sapphire substrate of any of the preceding examples, wherein at least one pin is disposed on the sapphire substrate, and at least one electrically connecting port is disposed on the pin.
6. A light emitting diode (LED) chip, providing light in multi-directions, comprising:
   a sapphire substrate of any of the preceding examples; and a plurality of light emitting diode (LED) structures, disposed on the growth surface and forming a first main surface where light emitted from with at least a part of the growth surface without the LED structures, and each of the LED structures comprises a first electrode and a second electrode,
   wherein light emitted from at least one of the LED structures passes through the sapphire substrate and emerges from the second main surface.
7. A light emitting diode (LED) chip, providing light in multi-directions, comprising:
   a sapphire substrate of any of the preceding examples; and at least one light emitting diode (LED) structures, disposed on the growth surface and forming a first main surface where light emitted from with at least a part of the growth surface without the LED structure, and the LED structure comprises a first electrode and a second electrode,
   wherein the LED chip has a beam angle greater than 180 degrees, and at least a part of light beams emitted from the LED structure pass through the sapphire substrate and emerge from the second main surface.
8. The LED chip of example 6, further comprising wavelength conversion layers respectively disposed on the first main surface and the second main surface, wherein a ratio of fluorescent powder concentration in the different wavelength conversion layers ranges from 1:0.5 to 1:3.
9. An illumination device, comprising: a LED chip of example 6; and a supporting base, wherein the LED chip is disposed on the supporting base.
10. The illumination device of example 9, wherein a first angle exists between the LED chip and the supporting base, and the first angle ranges from 30 degrees to 150 degrees.
11. The illumination device of example 9, further comprising a plurality of the LED chips, wherein at least some of the LED chips are point-symmetrically disposed on the supporting base or line-symmetrically disposed on the supporting base.
12. The illumination device of example 9, further comprising another LED chip, wherein one of the LED chips stands on the supporting base and the other one lies on the supporting base.
13. The illumination device of example 9, further comprising a support coupled to the supporting base, wherein the support is flexible and the LED chip is coupled to the support.
14. An illumination device, comprising:
   a LED chip of example 6; and a support, wherein the LED chip is disposed on the support.
15. The illumination device of example 14, wherein a material of the support includes one of selected from metal, composite metallic material, copper conductor, electric wire, ceramic substrate or printed circuit board.

## Claims

1. An illumination device, comprising:
- a LED chip (1), providing light in multi-directions, wherein the LED chip (1) comprises:
a sapphire substrate (2) with a growth surface (210) and a second surface (21B) opposite to the growth surface (210), and
a plurality of LED structures (3, 14) disposed on the growth surface (210) and having a plurality of light emitting surfaces (34) not covered by the sapphire substrate (2), whereby the plurality of light emitting surfaces (34) not covered by the sapphire substrate (2) and at least a part of the growth surface (210) without the LED structures form a first main surface (21A) where light is emitted from, and
wherein light emitted from at least one of the LED structures (3, 14) passes through the sapphire substrate (2) and emerges from the second surface (21B);
- a first support (62) connected to the sapphire substrate (2) of the LED chip (1);
- a bonding layer (63) formed between the LED chip (1) and the first support (62);
- a supporting base (5) associated with the first support (62); and
- a lamp housing (7) covering the LED chip, the first support, the bonding layer, and the supporting base.

2. The illumination device of claim 1, wherein the first support (62) is formed as a monolithically integrated part of the supporting base (5).

3. The illumination device of claim 1, wherein the sapphire substrate (2) has a non-planar surface including a plurality of convex or concave structures.

4. The illumination device of claim 1, further comprising a wavelength conversion layer (4) disposed on the first main surface (21A) and the second surface (21B), and in direct contact with the plurality of LED structures (3, 14).

5. The illumination device of claim 1, wherein the sapphire substrate (2) has a thickness greater than or equal to 200 micrometers.

6. The illumination device of claim 1, wherein the sapphire substrate (2) is transparent to light from the plurality of LED structures (3, 14).

7. The illumination device of claim 1, further comprising another LED chip (1), wherein the another LED chip (1) comprises another sapphire substrate (2) and is connected to a second support (62) separated from the first support (62) of the LED chip (1).

8. The illumination device of claim 7, wherein the second support (62) and the supporting base (5) are arranged to form an angle ranging from 30 degrees to 150 degrees.

9. The illumination device of claim 7, wherein the another LED chip (1) comprises a third surface, the first surface (21A) of the LED chip (1) and the third surface (21A) of the another LED chip face to different directions.

10. The illumination device of claim 1, wherein the plurality of LED structures (3, 14) comprises a plurality of side surfaces, the LED chip (1) comprises an insulating layer (20) contacting the plurality of side surfaces.

11. The illumination device of claim 10, wherein the LED chip (1) comprises a conductive pattern (22) covering the insulating layer (20) and the plurality of side surfaces.

12. The illumination device of claim 1, wherein the LED chip (1) is disposed on the supporting base (5).

13. The illumination device of claim 1, wherein the lamp housing (7) has a geometric central axis and the sapphire substrate (2) of the LED chip (1) is parallel with the geometric central axis.

14. The illumination device of claim 1, wherein the sapphire substrate (2) of the LED chip (1) is inclined with respect to the supporting base (5).
